# EUROPÄISCHE PATENTSCHRIFT

(11) **EP 3 871 933 B1**
(45) Veröffentlichungstag und Bekanntmachung des Hinweises auf die Patenterteilung: **15.11.2023**
(21) Anmeldenummer: 21167543.4
(22) Anmeldetag: 13.08.2018
(51) Int. Cl.: B60T 17/22, G01M 17/08, B61L 15/00, G01R 31/00

(54) **TESTEINRICHTUNG UND TESTVERFAHREN FÜR EIN ELEKTRO-PNEUMATISCHES BREMSSYSTEM VON ZÜGEN**
TEST DEVICE AND TEST METHOD FOR AN ELECTRO-PNEUMATIC BRAKE SYSTEM OF TRAINS
DISPOSITIF D'ESSAI ET PROCÉDÉ D'ESSAI D'UN SYSTÈME DE FREINAGE ÉLECTRO-PNEUMATIQUE DES TRAINS

(30) Priorität: 21.08.2017 DE 102017214553
(43) Veröffentlichungstag der Anmeldung: 01.09.2021
(62) Teilanmeldung aus: 18765010.6
(73) Patentinhaber: KNORR-BREMSE Systeme für Schienenfahrzeuge GmbH, 80809 München (DE)
(72) Erfinder: SCHÖLL, Helmut, 81371 München (DE)
(74) Vertreter: Prüfer & Partner mbB Patentanwälte · Rechtsanwälte

(56) Entgegenhaltungen:
- EP-A1- 0 924 528
- EP-A1- 2 743 712
- DE-A1- 19 507 529
- US-A- 1 953 008

## Beschreibung

Die Erfindung betrifft eine Testeinrichtung für ein elektro-pneumatisches Bremssystem von Zügen, insbesondere eine Testeinrichtung für ein elektro-pneumatisches Bremssystem von Güterzügen, sowie ein entsprechendes Testverfahren.

In Zügen werden elektro-pneumatische Bremssysteme verwendet, um einerseits ein Bremssignal an einzelne Bremsen des Zugs pneumatisch zu übermitteln; andererseits werden zusätzlich elektrische Signale zur Übermittlung des Bremssignals verwendet, um das Bremssignal auch bei längeren Zügen rasch an die einzelnen Bremsen zu übermitteln.

Für einen Zugbetrieb ist es erforderlich, das Bremsverhalten eines Zugs zu kennen, um beispielsweise zu entscheiden, bis zu welcher Höchstgeschwindigkeit der Zug seinen vorgegebenen Bremsweg sicher einhalten kann. Dazu werden die so genannten Bremshundertstel verwendet, die sich als Kennzahl aus dem Bremsgewicht und dem Gesamtgewicht eines Zugs bestimmen lassen.

Um jedoch die rasche Signalübermittlung einer elektro-pneumatischen Steuerung des Bremssystems bei der Berechnung der Bremshundertstel anrechenbar zu machen, ist zumindest eine regelmäßige Prüfung der Funktionsfähigkeit der Zugsteuerleitung des Bremssystems erforderlich. Darüber hinaus bringt die elektrische Signalübertragung über Zugsteuerleitungen die Vorteile, dass Längskräfte in einem Zugverband durch gleichzeitiges Bremsen bzw. Lösen aller Wagen reduziert werden und ein rasches Lösen der Bremse sowie ein präziseres Einhalten eines vorgegebenen Geschwindigkeitsbereichs in einem automatischen Fahrbetrieb (AFB) möglich sind.

Jedoch ist insbesondere für Güterzüge, eine entsprechende Wagen-Ausrüstung für eine ep-Steuerung verhältnismäßig aufwendig und wird deshalb nicht eingesetzt.

In Dokument US 1 953 008 A ist eine Testeinrichtung für ein elektro-pneumatisches Bremssystem von Zügen offenbart, die eine Testeinrichtung-seitige Verbindungseinrichtung einer Schnittstelle, mit mindestens einem ersten Kontakt und einem zweiten Kontakt, zum Verbinden mit einer Bremssystem-seitigen Verbindungseinrichtung der Schnittstelle, einen Schalter mit einer ersten und einer zweiten Schalterstellung zum Verbinden des mindestens ersten Kontakts und zweiten Kontaktes miteinander, und eine mit dem Schalter in Reihe angeschlossene Anzeigeeinrichtung aufweist.

Die Dokumente EP 0 924 528 A1, DE 195 07 529 A1 und EP 2 743 712 A1 offenbaren ebenfalls Testeinrichtungen, die eine Testeinrichtung-seitige Verbindungseinrichtung einer Schnittstelle, mit mindestens einem ersten Kontakt und einem zweiten Kontakt, zum Verbinden mit einer weiteren Verbindungseinrichtung der Schnittstelle, einen Schalter mit einer ersten und einer zweiten Schalterstellung zum Verbinden des mindestens ersten Kontakts und zweiten Kontaktes miteinander, und eine mit dem Schalter in Reihe angeschlossene Anzeigeeinrichtung aufweist.

Der Erfindung liegt daher die Aufgabe zugrunde, eine Testeinrichtung und ein Testverfahren bereitzustellen mit denen eine Durchgängigkeit der ep-Zugsteuerleitung ep-Bremsen und die Bremsfunktion einfach und kostengünstig überwacht und geprüft werden kann. Die generell notwendige Wagenausrüstung für jeden Wagen beschränkt sich auf die ep-Zugsteuerleitungen inklusive Stecker und die ep-Magnetventile.

Die Aufgabe wird durch eine Testeinrichtung gemäß Anspruch 1 und ein Testverfahren gemäß Anspruch 3 gelöst. Vorteilhafte Weiterentwicklungen sind jeweils Gegenstand der abhängigen Ansprüche.

Durch einen Einsatz einer separaten Testeinrichtung für ein elektro-pneumatisches Bremssystem von Zügen, die über eine Testeinrichtung-seitige Verbindungseinrichtung einer Schnittstelle mit dem Bremssystem verbindbar ist, und in der ein Schalter zum Verbinden von mindestens einem ersten Kontakt und einem zweiten Kontakt der Schnittstelle sowie eine mit dem Schalter in Reihe angeschlossene Anzeigeeinrichtung vorgesehen ist, kann die Durchgängigkeit der ep-Zugsteuerleitungen und eine Bremsfunktion einfach geprüft werden.

In einer vorteilhaften Weiterbildung der zuvor genannten Testeinrichtungen ist die Testeinrichtung tragbar. Tragbar heißt in diesem Zusammenhang, dass sie ein Gewicht und Abmessungen hat, so dass sie von Hand einfach gegriffen und angehoben werden kann. Gegebenenfalls sind spezielle Griffe vorgesehen. Die Testeinrichtung wird für die Dauer eines Zugumlaufs fest am letzten Wagen eines Zuges installiert.

Gemäß einer Ausgestaltung, die nicht Teil der vorliegenden Erfindung ist, weist die Testeinrichtung ein erstes Bauelement, das Strom in einer Stromrichtung passieren lässt und in einer entgegengesetzten Stromrichtung sperrt, ein zweites Bauelement, das Strom in einer Stromrichtung passieren lässt und in einer entgegengesetzten Stromrichtung sperrt, und einen ersten Widerstand und einen zweiten Widerstand mit unterschiedlichen Widerstandswerten, die über das erste Bauelement mit dem ersten Kontakt verbunden sind, auf. Das erste

Bauelement ist angeschlossen, einen Stromfluss zwischen dem ersten Kontakt und dem zweiten Kontakt in einer ersten Richtung zu ermöglichen, und das zweite Bauelement ist mit der Anzeigeeinrichtung so in Reihe angeschlossen, dass es einen Stromfluss zwischen dem ersten Kontakt und dem zweiten Kontakt in einer zu der ersten Richtung entgegengesetzten zweiten Richtung ermöglicht. Der Schalter ist als Umschalter ausgebildet und ist so verbunden, dass er, in einer ersten Schalterstellung, den ersten Kontakt über das erste Bauelement und den ersten Widerstand mit dem zweiten Kontakt verbindet, und, in einer zweiten Schalterstellung, den ersten Kontakt sowohl über das erste Bauelement und den zweiten Widerstand als auch über das zweite Bauelement und die Anzeigeeinrichtung mit dem zweiten Kontakt verbindet.

Durch diesen Aufbau ist es möglich, in der ersten Schalterstellung, einen Zugschluss zu überwachen, das heißt, die Durchgängigkeit der ep-Zugsteuerleitungen permanent zu prüfen. Durch einen Stromkreis, der innerhalb der Testeinrichtung durch eine Verbindung des ersten Bauelements mit dem ersten Kontakt, das erste Bauelement, den ersten Widerstand, den Umschalter in seiner ersten Schalterstellung und eine Verbindung des Umschalters mit dem zweiten Kontakt gebildet wird, kann Strom in der ersten Richtung durch die ep-Zugsteuerleitungen fließen und somit ist es möglich, einen Zugschluss mit einem definierten Schleifenwiderstand des ersten Widerstands zu überwachen.

In einer zweiten Schalterstellung ist es durch einen Stromkreis, der innerhalb der Testeinrichtung durch eine Verbindung des ersten Bauelements mit dem ersten Kontakt, das erste Bauelement, den zweiten Widerstand, den Umschalter in seiner zweiten Schalterstellung und eine Verbindung des Umschalters mit dem zweiten Kontakt gebildet wird, beim Fließen des Stroms in der ersten Richtung möglich, den Schleifenwiderstand des dazwischengeschalteten Widerstands, und somit des Zugschlusses, zu verändern, und somit quasi ein Bremssignal ("Bremsprobe-Endwagen") an ein elektro-pneumatisches Steuergerät einer Lokomotive zu senden.

Ein Steuersignal ("ep-Bremsen"), das von dem elektro-pneumatischen Steuergerät als Reaktion auf das Bremssignal ("Bremsprobe-Endwagen") ausgegeben wird, ändert die Potentiale an den ep-Zugsteuerleitungen. Somit kann dann Strom in der zweiten Richtung, die zu der ersten Richtung entgegengesetzt ist, nicht mehr durch den Stromkreis, der durch eine Verbindung des ersten Bauelements mit dem ersten Kontakt, das erste Bauelement, den zweiten Widerstand, den Umschalter in seiner zweiten Schalterstellung und eine Verbindung des Umschalters mit dem zweiten Kontakt gebildet wird, fließen, sondern fließt durch einen Stromkreis, der innerhalb der Testeinrichtung durch eine Verbindung des zweiten Bauelements mit dem ersten Kontakt, das zweite Bauelement, die Anzeigeeinrichtung, den Umschalter in seiner zweiten Schalterstellung und eine Verbindung des Umschalters mit dem zweiten Kontakt gebildet wird, und die Anzeigeeinrichtung kann das Steuersignal ("ep-Bremsen") anzeigen.

In einer Weiterbildung dieser Testeinrichtung, die nicht Teil der vorliegenden Erfindung ist, weist der erste Widerstand einen Schleifenwiderstand von 1000 Ω auf, und der zweite Widerstand weist einen Schleifenwiderstand von 1600 Ω auf. Durch eine Widerstandsänderung bei einem Umschalten des Umschalters der Testeinrichtung kann das elektro-pneumatische Steuergerät in einem Bremssystem nach UIC 541-5 bzw. UIC 541-6 ein Bremssignal ("Bremsprobe-Endwagen") erkennen und melden und, nach einer Verzögerungszeit, das Steuersignal ("ep-Bremsen") automatisch ausgeben.

In einer anderen Weiterbildung dieser Testeinrichtung, die nicht Teil der vorliegenden Erfindung ist, weist der erste Widerstand einen Schleifenwiderstand von 1000 Ω auf, und der zweite Widerstand weist einen Schleifenwiderstand von 680 Ω auf. Durch die Widerstandsänderung bei einem Umschalten des Umschalters der Testeinrichtung kann das elektro-pneumatische Steuergerät in einem Bremssystem nach UIC 541-5 bzw. UIC 541-6 ein Bremssignal ("Bremsprobe-Endwagen") erkennen und das Steuersignal ("ep-Bremsen") unmittelbar ausgeben.

Erfindungsgemäß weist die Testeinrichtung zusätzlich einen dritten Kontakt zum Verbinden mit dem Bremssystem auf. Der Schalter ist als mehrpoliger Umschalter ausgebildet, hat eine erste und eine zweite Schalterstellung, und ist so verbunden, dass er, in der zweiten Schalterstellung, mit einem Pol, den ersten Kontakt über die Anzeigeeinrichtung mit dem zweiten Kontakt verbindet und, mit einem anderen Pol, den ersten Kontakt mit dem dritten Kontakt verbindet.

Durch diesen Aufbau ist es möglich, durch einen Stromkreis, der innerhalb der Testeinrichtung durch eine Verbindung des ersten Pols des Umschalters mit dem ersten Kontakt, den Umschalter in seiner zweiten Schalterstellung und die Verbindung des ersten Pols des Umschalters mit dem zweiten Kontakt gebildet wird, einen Fahrgastnotbrems-Schwingkreis kurzzuschließen, und somit das Bremssignal ("Fahrgastnotbremse") an das elektro-pneumatische Steuergerät zu geben, so dass das Steuersignal ("ep-Bremsen") ausgegeben werden kann. Gleichzeitig ist es möglich, durch einen Stromkreis, der innerhalb der Testeinrichtung durch eine Verbindung des zweiten Pols des Umschalters über die Anzeigeeinrichtung mit dem ersten Kontakt, den Umschalter in seiner zweiten Schalterstellung und die Verbindung des zweiten Pols des Umschalters mit dem zweiten Kontakt gebildet ist, das Steuersignal ("ep-Bremsen") an der Anzeigeeinrichtung anzuzeigen, solange der Umschalter in seiner zweiten Schalterstellung ist.

In einem erfindungsgemäßen Verfahren wird, in der Schnittstelle, die Testeinrichtung-seitige Verbindungseinrichtung mit einer Bremssystem-seitigen Verbindungseinrichtung manuell verbunden und der Schalter wird manuell in die zweite Schalterstellung umgeschaltet, wodurch die Testeinrichtung das Umschalten des Schalters in die zweite Schalterstellung an das elektro-pneumatischen Bremssystem signalisiert ("Fahrgastnotbremse"). Das elektro-pneumatische Bremssystem schaltet aufgrund der Signalisierung des Umschaltens des Schalters eine Bremsstellung von Zugbremsen und nachfolgend kann ein manuelles Überprüfen der Bremsstellung der Zugbremsen, beispielsweise durch ein Anlegen der Bremsen am letzten Wagen, und des Steuersignals ("ep-Bremsen") erfolgen.

Wenn die Testeinrichtung vorteilhafterweise mit der Bremssystem-seitigen Verbindungseinrichtung eines hintersten Wagens eines Zugs verbunden wird, kann eine Durchgängigkeit einer gesamten ep-Zugsteuerleitung durch sämtliche Wagen gleichzeitig geprüft werden.

Bei einem nicht zur Erfindung gehörenden Signalisieren des Umschaltens des Schalters in eine zweite Schalterstellung durch eine Änderung des Widerstands des Zugschlusses ("Bremsprobe-Endwagen") mit einer entsprechend ausgebildeten Testeinrichtung kann eine vorhandene Funktionalität eines elektro-pneumatischen Steuergeräts in einem Bremssystem nach UIC 541-5 oder UIC 541-6 genutzt werden.

Erfindungsgemäß wird bei einem Signalisieren des Umschaltens des Schalters in eine zweite Schalterstellung durch ein Kurzschließen eines Fahrgastnotbrems-Schwingkreises ("Fahrgastnotbremse") mit einer entsprechenden Testeinrichtung eine vorhandene Funktionalität eines elektro-pneumatischen Steuergeräts in einem Bremssystem nach UIC 558 genutzt.

Bei einem vorteilhaften manuellen Schalten der Bremsstellung, beispielsweise durch einen Lokführer, kann das elektro-pneumatische Steuergerät der Lokomotive eine geringere Funktionalität aufweisen, wodurch eine Komplexität verringert wird. Die Prüfung wird bei einem manuellen Schalten der Bremsstellung von beispielsweise einem Lokführer auf der Lokomotive und einem Bremsprobenberechtigten an der Testeinrichtung durchgeführt.

Wenn andererseits das Schalten der Bremsstellung vorteilhafterweise automatisch erfolgt, kann die Prüfung der Zugsteuerleitungen des elektro-pneumatischen Bremssystems von nur einer Person alleine durchgeführt werden.

Das Verfahren kann vorteilhafterweise den Schritt eines Prüfens eines Normalzustands für eine ordnungsgemäße Durchgängigkeit von Zugsteuerleitungen des elektro-pneumatischen Bremssystems während eines Fahrbetriebs enthalten.

Weiterhin kann das Prüfen des Normalzustands in dem Fahrbetrieb vorteilhafterweise dauerhaft durchgeführt werden.

Die Erfindung wird nun anhand von Ausführungsbeispielen unter Bezugnahme auf die beigefügten Zeichnungen erläutert.

Insbesondere zeigt
- Fig. 1: eine prinzipielle Darstellung eines Zugs mit einem elektro-pneumatischen Bremssystem und einer damit verbundenen Testeinrichtung;
- Fig. 2: einen prinzipiellen Schaltplan einer Testeinrichtung, die nicht Teil der Erfindung ist; und
- Fig. 3: einen prinzipiellen Schaltplan einer erfindungsgemäßen Testeinrichtung.

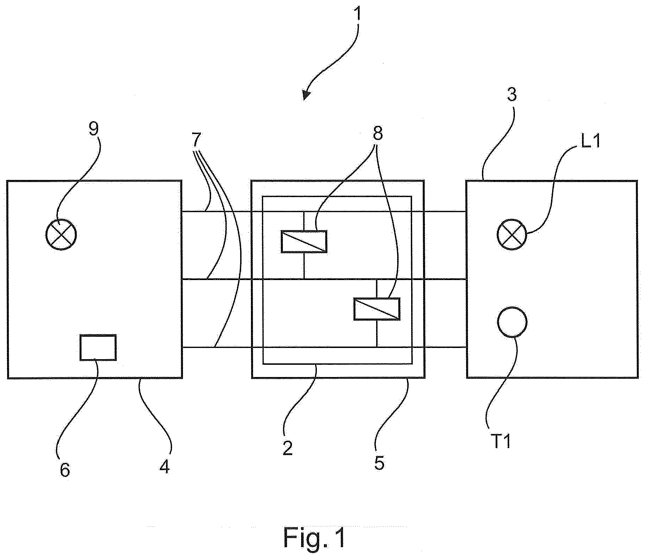

**Fig. 1** zeigt eine prinzipielle Darstellung eines Zugs 1 mit einem elektro-pneumatischen Bremssystem 2 und einer damit verbundenen Testeinrichtung 3. Der Zug 1 besteht aus einer Lokomotive 4 und mehreren Wagen 5, wobei in Fig. 1 nur ein Wagen 5 dargestellt ist.

Die Lokomotive 4 weist neben den Antriebseinrichtungen und weiteren Funktionsmodulen ein elektro-pneumatisches Steuergerät 6 gemäß den Bestimmungen der UIC 541-5 bzw. UIC 541-6 oder UIC 558 auf.

Ferner ist eine Überwachungseinrichtung vorgesehen, die in dem elektro-pneumatischen Steuergerät 6 enthalten sein kann, und die über sogenannte "ep-Zugsteuerleitungen" 7 (elektro-pneumatische Zugsteuerleitungen) ein später beschriebenes Überwachungssignal in den Zug 1 einspeist und auswertet. Das entsprechende Überwachungssignal kann kontinuierlich ausgewertet werden, und kann somit auch während eines Fahrbetriebs ausgewertet werden. Durch diese Auswertung kann beispielsweise eine Rückmeldung eines Zustands "Bremsprobe- Endwagen" erkannt und über eine Zustandsanzeigeeinrichtung 9, beispielsweise einen Leuchtmelder oder eine Diagnosemeldeeinrichtung, signalisiert werden.

Um die kontinuierliche Überwachung einer Durchgängigkeit der ep-Zugsteuerleitungen 7 zu ermöglichen, kann die Überwachungseinrichtung die drei Zustände "Normalzustand", "Bremsprobe- Endwagen" und "ungültiger Zustand" unterscheiden. Der "Normalzustand" bedeutet, dass sich die ep-Zugsteuerleitungen 7 in einem ordnungsgemäßen Zustand befinden, d.h., dass kein Kabelbruch oder ein Kurzschluss vorliegt, was ansonsten als "ungültiger Zustand" erkannt wird. Der "Normalzustand" bedeutet jedoch nicht zwingend, dass das elektro-pneumatische Bremssystem 2 störungsfrei arbeitet, da die ep-Zugsteuerleitungen 7 zwar durchgängig sein können, aber an anderen Komponenten Fehler auftreten können, was aber durch eine Bremsprobe erkannt werden kann. Auf den Zustand "Bremsprobe-Endwagen" wird nachstehend eingegangen.

In den Wagen 5 sind jeweils die ep-Zugsteuerleitungen 7 nach UIC 541-5 bzw. UIC 541-6 oder UIC 558 vorgesehen. Ferner sind Stecker und Kupplungen nach UIC 541-5 bzw. UIC 541-6 oder UIC 558 an den ep-Zugsteuerleitungen 7 vorhanden. Darüber hinaus sind ep-Magnetventile 8 als sogenannte "EPZ-Einheiten" als Zusatz zu Steuerventilen zum gleichzeitigen Absenken oder Erhöhen eines Hauptluftleitungsdrucks (HL-Druck) in den Wagen 5 vorgesehen. Die Verbindung zwischen dem Wagen 5 und der Testeinrichtung 3 wird über eine Schnittstelle 10 realisiert. Die Schnittstelle 10 besteht aus einer Bremssystem-seitigen Verbindungseinrichtung und einer Testeinrichtung-seitigen Verbindungseinrichtung und ist eine normgerechte Steckverbindung nach UIC 541-5 bzw. UIC 541-6 oder UIC 558, kann aber alternativ auch in einer anderen Form ausgeführt sein.

Die Testeinrichtung 3 weist einen Taster T1 und einer Anzeigeeinrichtung L1 auf.

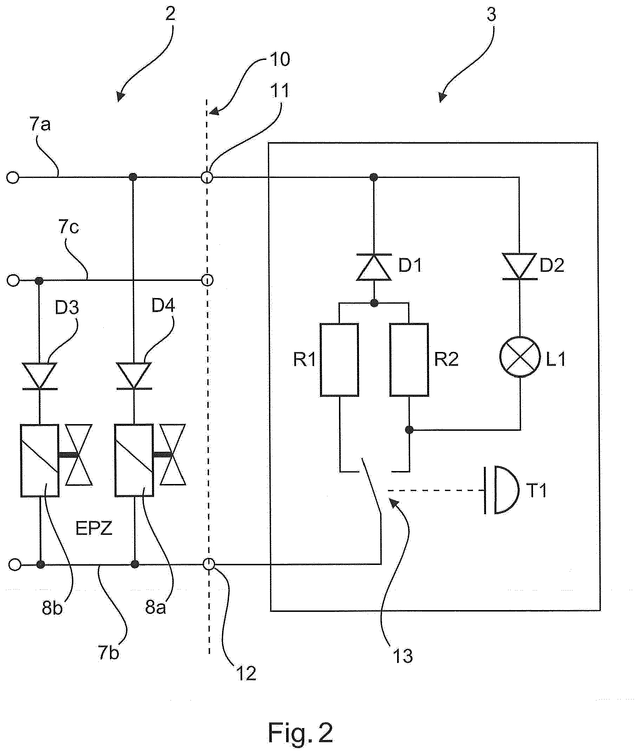

**Fig. 2** zeigt einen prinzipiellen Schaltplan einer nicht zur Erfindung gehörenden Testeinrichtung 3, die über eine Testeinrichtung-seitige Verbindungseinrichtung der Schnittstelle 10 mit einer Bremssystem-seitigen Verbindungseinrichtung verbindbar ist. Diese Testeinrichtung 3 ist für ein elektro-pneumatisches Bremssystem 2 gemäß den Bestimmungen der UIC 541-5 bzw. UIC 541-6 geeignet.

Die Testeinrichtung 3 weist in der Testeinrichtung-seitigen Verbindungseinrichtung der Schnittstelle 10 einen ersten Kontakt 11 und einen zweiten Kontakt 12 zum Verbinden mit dem elektro-pneumatischen Bremssystem 2 auf. Ferner ist ein Schalter 13 in der Testeinrichtung 3 vorgesehen, um den ersten Kontakt 11 und den zweiten Kontakt 12 zu verbinden. Der Schalter 13 wird über eine Betätigung des Tasters T1 (Fig. 1) umgeschaltet, kann alternativ aber auch eine andere Betätigungseinrichtung aufweisen.

Darüber hinaus ist die Anzeigeeinrichtung L1 mit dem Schalter 13 in Reihe verbunden.

Die Testeinrichtung 3 weist ein erstes Bauelement D1, hier in Form einer Diode, das Strom in einer Stromrichtung passieren lässt und in einer entgegengesetzten Stromrichtung sperrt, ein zweites Bauelement D2, hier ebenfalls in Form einer Diode, das Strom in einer Stromrichtung passieren lässt und in einer entgegengesetzten Stromrichtung sperrt, und einen ersten Widerstand R1 und einen zweiten Widerstand R2 mit unterschiedlichen Widerstandswerten auf.

Der erste Widerstand R1 und der zweite Widerstand R2 sind über das erste Bauelement D1 mit dem ersten Kontakt 11 verbundenen, wobei das erste Bauelement D1 angeschlossen ist, einen Stromfluss zwischen dem ersten Kontakt 11 und dem zweiten Kontakt 12 in einer ersten Richtung zu ermöglichen. Das zweite Bauelement D2 ist mit der Anzeigeeinrichtung L1 so in Reihe angeschlossen, um einen Stromfluss zwischen dem ersten Kontakt 11 und dem zweiten Kontakt 12 in einer zu der ersten Richtung entgegengesetzten zweiten Richtung zu ermöglichen. Der Schalter 13 ist als Umschalter ausgebildet, und ist so verbunden, dass er, in einer ersten Schalterstellung, wie in Fig. 2 dargestellt, den ersten Kontakt 11 über das erste Bauelement D1 und den ersten Widerstand R1 mit dem zweiten Kontakt 12 verbindet und, in einer nicht dargestellten zweiten Schalterstellung, den ersten Kontakt 11 sowohl über das erste Bauelement D1 und den zweiten Widerstand R2 als auch über das zweite Bauelement D2 und die Anzeigeeinrichtung L1 mit dem zweiten Kontakt 12 verbindet.

Der erste Widerstand R1 weist einen Widerstandswert von 1000 Ω auf und der zweite Widerstand weist einen Widerstandswert von 1600 Ω auf. Alternativ weist der erste Widerstand R1 einen Widerstandswert von 1000 Ω auf und der zweite Widerstand R2 weist einen Widerstandswert von 680 Ω auf. Diese Widerstandswerte definieren später beschriebene gemäß UIC 541-5 bzw. UIC 541-6 festgelegte Funktionen. In einer weiteren Alternative können die Widerstandswerte auch andere Werte annehmen, solange die Widerstandswerte für den ersten Widerstand R1 und den zweiten Widerstand R2 ausreichend sicher unterscheidbar sind.

Das elektro-pneumatische Bremssystem 2 weist die ep-Magnetventile 8a, 8b auf, wobei das ep-Magnetventil 8a zum gleichzeitigen Verringern des HL-Drucks in den Wagen 5, also zum Bremsen, und das ep-Magnetventil 8b zum gleichzeitigen Erhöhen des HL-Drucks in den Wagen 5, also zum Lösen der Bremsen, vorgesehen sind.

Das ep-Magnetventil 8a zum Bremsen ist auf einer Seite über eine Diode D4 mit einer ersten ep-Zugsteuerleitung 7a und an der anderen Seite mit einer zweiten ep-Zugsteuerleitung 7b verbunden. Die Diode D4 bewirkt, dass bei einem Schalten einer Bremsstellung von Zugbremsen ("ep-Bremsen") Strom durch die Diode D4 und damit durch eine Magnetspule des ep-Magnetventils 8a fließt.

Das ep-Magnetventil 8b zum Lösen der Bremsen ist auf einer Seite mit einer weiteren ep-Zugsteuerleitung 7c und auf der anderen Seite mit der zweiten ep-Zugsteuerleitung 7b verbunden. Eine weitere Diode D3 bewirkt, dass bei einem Schalten eines Lösens der Bremsstellung von Zugbremsen ("ep-Lösen") Strom durch die Diode D3 und damit durch eine Magnetspule des ep-Magnetventils 8b fließt.

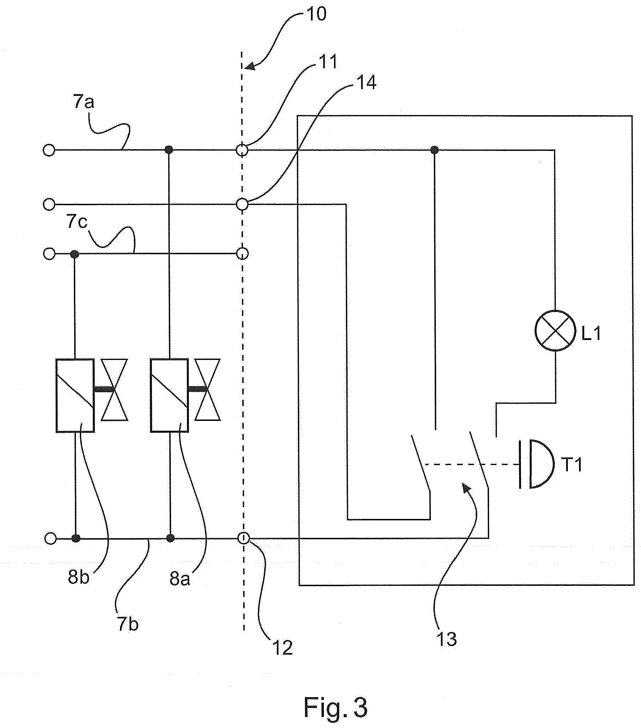

**Fig. 3** zeigt einen prinzipiellen Schaltplan einer erfindungsgemäßen Testeinrichtung 3. Die Testeinrichtung 3 ist für ein elektro-pneumatisches Bremssystem 2 gemäß den Bestimmungen der UIC 558 geeignet.

Auch in diesem Ausführungsbeispiel weist die Testeinrichtung 3 in einer Testeinrichtung-seitigen Verbindungseinrichtung der Schnittstelle 10 einen ersten Kontakt 11 und einen zweiten Kontakt 12 zum Verbinden mit dem elektro-pneumatischen Bremssystem 2 auf. Ferner ist ein Schalter 13 in der Testeinrichtung 3 vorgesehen, um den ersten Kontakt 11 und den zweiten Kontakt 12 zu verbinden. Der Schalter 13 wird über eine Betätigung des Tasters T1 (Fig. 1) umgeschaltet, kann alternativ aber auch eine andere Betätigungseinrichtung aufweisen.

In der Testeinrichtung 3 in diesem Ausführungsbeispiel ist wie im zuvor beschriebenen Ausführungsbeispiel auch die Anzeigeeinrichtung L1 vorgesehen, die in Reihe mit dem Schalter 13 angeschlossen ist.

Diese Testeinrichtung 3 weist, im Unterschied zu der in Fig. 2 gezeigten Testeinrichtung 3, zusätzlich einen dritten Kontakt 14 zum Verbinden mit dem elektro-pneumatischen Bremssystem 2 auf. Der Schalter 13 ist als mehrpoliger Umschalter ausgebildet, und ist so verbunden, dass er eine hier gezeigte erste Schalterstellung und eine nicht gezeigte zweite Schalterstellung hat. In der zweiten Schalterstellung, verbindet der Schalter 13, mit einem Pol, den ersten Kontakt 11 über die Anzeigeeinrichtung L1 mit dem zweiten Kontakt 12, und, mit einem weiteren Pol, den ersten Kontakt 11 mit dem dritten Kontakt 14.

Im Betrieb wird die Testeinrichtung-seitige Verbindungseinrichtung der Schnittstelle 10 mit der Bremssystem-seitigen Verbindungseinrichtung manuell verbunden. Das elektro-pneumatische Steuergerät 6 wird vor oder nach dem Verbinden mit der Testeinrichtung 3 beispielsweise durch einen Lokführer oder einen Bremsprobenberechtigten, eingeschaltet.

Anschließend wird, jedoch nicht zur Erfindung gehörig, beispielsweise durch den Bremsprobenberechtigten, der Schalter 13, beispielsweise über den Taster T1, manuell in die zweite Schalterstellung umgeschaltet, und dabei wird, wie später beschrieben, das Umschalten des Schalters 13 in die zweite Schalterstellung durch die Testeinrichtung 3 an das elektro-pneumatische Bremssystem signalisiert ("Bremsprobe-Endwagen"). Aufgrund des Signalisierens des Umschaltens des Schalters in die zweite Schalterstellung, wird, wie später beschrieben, entweder manuell oder automatisch ausgelöst, eine Bremsstellung von Zugbremsen durch das elektro-pneumatische Bremssystem 2 geschaltet ("ep-Bremsen"). Die Bremsstellung der Zugbremsen, nämlich ein Anlegen der Bremsen am letzten Wagen aufgrund der HL-Druckabsenkung, und das Steuersignal ("ep-Bremsen") an der Anzeigeeinrichtung L1 werden dann manuell überprüft, um die Durchgängigkeit der ep-Zugsteuerleitungen 7 und die Funktion des elektro-pneumatischen Bremssystems 2 zu überprüfen.

Die Testeinrichtung 3 ist über die Testeinrichtung-seitige Verbindungseinrichtung an einem hintersten Wagen 5 mit der Bremssystem-seitigen Verbindungseinrichtung der Schnittstelle 10 verbunden, so dass die ep-Zugsteuerleitungen 7 des gesamten Zugs 1 in einem einzigen Prüfvorgang überprüft werden können.

Das Signalisieren des Umschaltens des Schalters 13 in die zweite Schalterstellung kann durch eine Änderung des Widerstands eines Zugschlusses erfolgen. Das elektro-pneumatische Bremssystem 2 erkennt hier dann einen zu hohen Schleifenwiderstand in der Überwachungsschleife ("Bremsprobe-Endwagen"), und das elektro-pneumatische Steuergerät 6 signalisiert dies über die Zustandsanzeigeeinrichtung 9. Das Schalten der Bremsstellung durch das elektro-pneumatische Bremssystem 2 wird dann durch die Anzeigeeinrichtung L1 an der Testeinrichtung 3 angezeigt. Ein Signalisieren in dieser Form wird bei einem pneumatischen Bremssystem 2 gemäß den Bestimmungen der UIC 541-5 bzw. UIC 541-6 durchgeführt.

Das Schalten der Bremsstellung ("ep-Bremsen") kann manuell erfolgen. Bei einer Bremsprobe quittiert ein Lokführer das Signal ("Bremsprobe-Endwagen") an dem elektro-pneumatischen Steuergerät 6 durch das Umschalten des Schalters in die zweite Schalterstellung mit einer Bremsstellung eines Führerbremsventils ("ep-Bremsen").

Andererseits kann das Schalten der Bremsstellung ("ep-Bremsen") durch das elektro-pneumatische Bremssystem 2 automatisch erfolgen. Dazu wird an dem elektro-pneumatischen Steuergerät 6 ein Modus "ep-Bremsprobe" eingeschaltet. Der Schalter 13 der Testeinrichtung 3 wird von dem Bremsprobenberechtigten beispielsweise über das Betätigen des Tasters T1 in die zweite Schalterstellung geschaltet. Das elektro-pneumatische Bremssystem 2 erkennt über einen Schleifenwiderstand von 1600 Ω in der Überwachungsschleife den Zustand "Bremsprobe-Endwagen" und quittiert dies durch eine automatische Ausgabe von "ep-Bremsen" über die entsprechende ep-Zugsteuerleitung 7.

Erfindungsgemäß kann bei einem pneumatischen Bremssystem 2 gemäß den Bestimmungen der UIC 558 das Signalisieren des Umschaltens des Schalters in die zweite Schalterstellung durch ein Kurzschließen eines Fahrgastnotbrems-Schwingkreises erfolgen ("Fahrgastnotbremse"). Das ep-Steuergerät auf der Lokomotive erkennt dieses Kurzschließen und signalisiert dies als "Fahrgastnotbremse" über die Zustandsanzeigeeinrichtung 9, beispielsweise einen Leuchtmelder oder eine Statusmeldung. Der Lokführer quittiert diese Signalisierung mit einer Bremsstellung des Führerbremsventils ("ep-Bremsen"). Das Schalten der Bremsstellung durch das elektro-pneumatische Bremssystem 2 wird dann durch die Anzeigeeinrichtung L1 an der Testeinrichtung 3 angezeigt.

In einem zweiten Beispiel der Testeinrichtung 3 ist die Schnittstelle 10 des ersten Beispiels eine normgerechte Steckverbindung.

Bei einem dritten Beispiel der Testeinrichtung 3 ist die Testeinrichtung 3 gemäß dem ersten oder zweiten Beispiel ausgebildet, tragbar zu sein.

In einem vierten Beispiel der Testeinrichtung 3 weist die Testeinrichtung 3 gemäß einem der ersten bis dritten Beispiele zusätzlich ein erstes Bauelement D1, das Strom in einer Stromrichtung passieren lässt und in einer entgegengesetzten Stromrichtung sperrt, ein zweites Bauelement D2, das Strom in einer Stromrichtung passieren lässt und in einer entgegengesetzten Stromrichtung sperrt, und einen ersten Widerstand R1 und einen zweiten Widerstand R2 mit unterschiedlichen Widerstandswerten auf, wobei der erste Widerstand R1 und der zweite Widerstand R2 über das erste Bauelement D1 mit dem ersten Kontakt 11 verbunden sind, das erste Bauelement D1 angeschlossen ist, einen Stromfluss zwischen dem ersten Kontakt 11 und dem zweiten Kontakt 12 in einer ersten Richtung zu ermöglichen, das zweite Bauelement D2 und die Anzeigeeinrichtung L1 so in Reihe angeschlossen sind, um einen Stromfluss zwischen dem ersten Kontakt 11 und dem zweiten Kontakt 12 in einer zu der ersten Richtung entgegengesetzten zweiten Richtung zu ermöglichen, und der Schalter 13 als Umschalter ausgebildet ist, und so mit dem ersten Kontakt 11 und dem zweiten Kontakt 12 verbunden ist, dass er, in einer ersten Schalterstellung, den ersten Kontakt 11 über das erste Bauelement D1 und den ersten Widerstand R1 mit dem zweiten Kontakt 12 verbindet, und, in einer zweiten Schalterstellung, den ersten Kontakt 11 sowohl über das erste Bauelement D1 und den zweiten Widerstand R2 als auch über das zweite Bauelement D2 und die Anzeigeeinrichtung L1 mit dem zweiten Kontakt 12 verbindet.

Bei einem fünften Beispiel der Testeinrichtung 3 weist in der Testeinrichtung 3 gemäß dem zweiten bis vierten Beispiel der erste Widerstand R1 einen Widerstandswert von 1000 Ω auf und der zweite Widerstand R2 einen Widerstandswert von 1600 Ω auf.

Bei einem sechsten Beispiel der Testeinrichtung 3 weist in der Testeinrichtung 3 gemäß dem zweiten bis vierten Beispiel der erste Widerstand R1 einen Widerstandswert von 1000 Ω auf und der zweite Widerstand R2 einen Widerstandswert von 680 Ω auf.

In einem siebten Beispiel der Testeinrichtung 3 weist die Testeinrichtung 3 gemäß einem von dem ersten bis dritten Beispiel zusätzlich einen dritten Kontakt 14 zum Verbinden mit dem Bremssystem 2 auf, der Schalter 13 ist als mehrpoliger Umschalter ausgebildet, der eine erste Schalterstellung und eine zweite Schalterstellung hat, und ist so mit dem ersten Kontakt 11 und dem zweiten Kontakt 12 verbunden, dass der Schalter 13 in der zweiten Schalterstellung, mit einem Pol, den ersten Kontakt 11 über die Anzeigeeinrichtung L1 mit dem zweiten Kontakt 12 verbindet, und, mit einem weiteren Pol, den ersten Kontakt 11 mit dem dritten Kontakt 14 verbindet.

In einem ersten Beispiel eines Testverfahrens für ein elektro-pneumatisches Bremssystem 2 von Zügen 1 mit einer Testeinrichtung 3 gemäß einem der vorangehenden Beispiele weist das Verfahren die Schritten auf: Manuelles Verbinden der Testeinrichtung-seitigen Verbindungseinrichtung der Schnittstelle 10 mit der Bremssystem-seitigen Verbindungseinrichtung; manuelles Umschalten des Schalters 13 in die zweite Schalterstellung; Signalisieren des Umschaltens des Schalters 13 in die zweite Schalterstellung an das elektro-pneumatischen Bremssystem 2 durch die Testeinrichtung 3; Schalten einer Bremsstellung von Zugbremsen durch das elektro-pneumatische Bremssystem 2 aufgrund des Signalisierens des Umschaltens des Schalters 13 in die zweite Schalterstellung; Anzeigen des Schaltens der Bremsstellung durch das elektro-pneumatische Bremssystem durch die Anzeigeeinrichtung L1; und manuelles Überprüfen der Bremsstellung der Zugbremsen und des Signals der Anzeigeeinrichtung L1.

In einem zweiten Beispiel des Testverfahrens wird in dem Testverfahren gemäß dem ersten Beispiel die Testeinrichtung 3 an einem hintersten Wagen 5 mit der Bremssystem-seitigen Verbindungseinrichtung der Schnittstelle 10 verbunden.

Bei einem dritten Beispiel des Testverfahrens erfolgt in dem Testverfahren gemäß dem ersten oder zweiten Beispiel mit einer Testeinrichtung 3 gemäß dem fünften oder sechsten Beispiel das Signalisieren des Umschaltens des Schalters 13 in die zweite Schalterstellung durch eine Änderung des Widerstands eines Zugschlusses.

Bei einem vierten Beispiel des Testverfahrens erfolgt in dem Testverfahren gemäß dem ersten oder zweiten Beispiel mit einer Testeinrichtung 3 gemäß dem siebten Beispiel das Signalisieren des Umschaltens des Schalters 13 in die zweite Schalterstellung durch ein Kurzschließen eines Fahrgastnotbrems-Schwingkreises.

Entsprechend einem fünften Beispiel des Testverfahrens erfolgt in einem Testverfahren gemäß dem ersten bis dritten Beispiel das Schalten der Bremsstellung manuell. Entsprechend einem sechsten Beispiel des Testverfahrens erfolgt in einem Testverfahren gemäß dem ersten bis vierten Beispiel das Schalten der Bremsstellung automatisch.

Ein siebtes Beispiel des Testverfahrens weist in einem Testverfahren entsprechend einem vorangehenden Beispiel den Schritt auf: Prüfens eines Normalzustands für eine ordnungsgemäße Durchgängigkeit von Zugsteuerleitungen des elektro-pneumatischen Bremssystems während eines Fahrbetriebs.

Bei einem achten Beispiel des Testverfahrens wird in dem Testverfahren gemäß dem siebten Beispiel das Prüfen in dem Fahrbetrieb dauerhaft durchgeführt.

### BEZUGSZEICHENLISTE

- 1: Zug
- 2: elektro-pneumatisches Bremssystem
- 3: Testeinrichtung
- 4: Lokomotive
- 5: Wagen
- 6: elektro-pneumatisches Steuergerät
- 7: ep-Zugsteuerleitungen
- 8: ep-Magnetventile
- 9: Zustandsanzeigeeinrichtung
- 10: Schnittstelle
- 11: erster Kontakt
- 12: zweiter Kontakt
- 13: Schalter
- 14: dritter Kontakt

- D1: erstes Bauelement
- D2: zweites Bauelement
- L1: Anzeigeeinrichtung
- R1: erster Widerstand
- R2: zweiter Widerstand
- T1: Taster

## Patentansprüche

1. Testeinrichtung (3) für ein elektro-pneumatisches Bremssystem (2) von Zügen (1), die
eine Testeinrichtung-seitige Verbindungseinrichtung einer Schnittstelle (10), mit mindestens einem ersten Kontakt (11) und einem zweiten Kontakt (12), zum Verbinden mit einer Bremssystem-seitigen Verbindungseinrichtung der Schnittstelle (10),
einen Schalter (13) mit einer ersten und einer zweiten Schalterstellung zum Verbinden des mindestens ersten Kontakts (11) und zweiten Kontaktes (12) miteinander, und
eine mit dem Schalter (13) in Reihe angeschlossene Anzeigeeinrichtung (L1) aufweist
**dadurch gekennzeichnet, dass**
die Testeinrichtung (3) zusätzlich einen dritten Kontakt (14) zum Verbinden mit dem Bremssystem (2) aufweist,
der Schalter (13) als mehrpoliger Umschalter ausgebildet ist, der eine erste Schalterstellung und eine zweite Schalterstellung hat, und so mit dem ersten Kontakt (11) und dem zweiten Kontakt (12) verbunden ist, dass der Schalter (13) in der zweiten Schalterstellung,
mit einem Pol, den ersten Kontakt (11) über die Anzeigeeinrichtung (L1) mit dem zweiten Kontakt (12) verbindet, und,
mit einem weiteren Pol, den ersten Kontakt (11) mit dem dritten Kontakt (14) verbindet.

2. Testeinrichtung (3) gemäß Anspruch 1, wobei die Testeinrichtung (3) ausgebildet ist, tragbar zu sein.

3. Testverfahren für ein elektro-pneumatisches Bremssystem (2) von Zügen (1) mit einer Testeinrichtung (3) gemäß einem der vorangehenden Ansprüche mit den Schritten:
- Manuelles Verbinden der Testeinrichtung-seitigen Verbindungseinrichtung der Schnittstelle (10) mit der Bremssystem-seitigen Verbindungseinrichtung;
- manuelles Umschalten des Schalters (13) in die zweite Schalterstellung;
- Signalisieren des Umschaltens des Schalters (13) in die zweite Schalterstellung an das elektro-pneumatischen Bremssystem (2) durch die Testeinrichtung (3), wobei das Signalisieren des Umschaltens des Schalters (13) in die zweite Schalterstellung durch ein Kurzschließen eines Fahrgastnotbrems-Schwingkreises erfolgt;
- Schalten einer Bremsstellung von Zugbremsen durch das elektro-pneumatische Bremssystem (2) aufgrund des Signalisierens des Umschaltens des Schalters (13) in die zweite Schalterstellung;
- Anzeigen des Schaltens der Bremsstellung durch das elektro-pneumatische Bremssystem durch die Anzeigeeinrichtung (L1);
- manuelles Überprüfen der Bremsstellung der Zugbremsen und des Signals der Anzeigeeinrichtung (L1).

4. Testverfahren gemäß Anspruch 3, wobei die Testeinrichtung (3) an einem hintersten Wagen (5) mit der Bremssystem-seitigen Verbindungseinrichtung der Schnittstelle (10) verbunden wird.

5. Testverfahren gemäß einem der Ansprüche 3 oder 4, wobei das Schalten der Bremsstellung manuell erfolgt.

6. Testverfahren gemäß einem der Ansprüche 3 oder 4, wobei das Schalten der Bremsstellung durch das elektro-pneumatische Bremssystem automatisch erfolgt.

7. Testverfahren gemäß einem der Ansprüche 3 bis 6, wobei das Verfahren den Schritt aufweist:
Prüfens eines Normalzustands für eine ordnungsgemäße Durchgängigkeit von Zugsteuerleitung des elektro-pneumatischen Bremssystems während eines Fahrbetriebs.

8. Testverfahren gemäß Anspruch 7, wobei das Prüfen in dem Fahrbetrieb dauerhaft durchgeführt wird.

## Claims

1. Test device (3) for an electro-pneumatic brake system (2) of trains (1) which has
a test-device-side connecting device of an interface (10), with at least one first contact (11) and one second contact (12), for connecting to a brake-system-side connecting device of the interface (10),
a switch (13) with a first and a second switch position for connecting the at least first contact (11) and second contact (12) to one another, and
a display device (L1) which is connected in series with the switch (13),
**characterized in that**
the test device (3) additionally has a third contact (14) for connecting to the brake system (2),
the switch (13) is designed as a multi-pole changeover switch which has a first switch position and a second switch position and is connected to the first contact (11) and the second contact (12) in such a way that in the second switch position the switch (13)
connects, with one pole, the first contact (11) to the second contact (12) via the display device (L1), and
connects, with a further pole, the first contact (11) to the third contact (14).

2. Test device (3) according to Claim 1, wherein the test device (3) is designed to be portable.

3. Test method for an electro-pneumatic brake system (2) of trains (1) having a test device (3) according to one of the preceding claims, comprising the steps:
- manually connecting the test-device-side connecting device of the interface (10) to the brake-system-side connecting device;
- manually switching over the switch (13) into the second switch position;
- signalling the switching over of the switch (13) into the second switch position to the electro-pneumatic brake system (2) by means of the test device (3), wherein the signalling of the switching over of the switch (13) into the second switch position is carried out by short-circuiting a passenger emergency brake oscillatory circuit;
- switching a brake position of train brakes by means of the electro-pneumatic brake system (2) on the basis of the signalling of the switching over of the switch (13) into the second switch position;
- displaying the switching of the brake position by the electro-pneumatic brake system by means of the display device (L1);
- manually checking the brake position of the train brakes and the signal of the display device (L1).

4. Test method according to Claim 3, wherein the test device (3) is connected at a rearmost car (5) to the brake-system-side connecting device of the interface (10) .

5. Test method according to either of Claims 3 and 4, wherein the switching of the brake position is carried out manually.

6. Test method according to either of Claims 3 and 4, wherein the switching of the brake position is carried out automatically by the electro-pneumatic brake system.

7. Test method according to one of Claims 3 to 6, wherein the method comprises the step:
checking a normal state for satisfactory integrity of the train control line of the electro-pneumatic brake system during a travel mode.

8. Test method according to Claim 7, wherein the checking is carried out continuously in the travel mode.

## Revendications

1. Dispositif (3) d'essai d'un système (2) électropneumatique de freinage de trains (1), qui a
un dispositif de liaison, du côté du dispositif d'essai, d'une interface (10), ayant au moins un premier contact (11) et un deuxième contact (12), pour la liaison à un dispositif de liaison, du côté du système de freinage, de l'interface (10),
un interrupteur (13) ayant une première et une deuxième position d'interrupteur pour la liaison du au moins un premier contact (11) et du deuxième contact (12) entre eux, et
un dispositif (L1) d'affichage monté en série avec l'interrupteur (13),
**caractérisé en ce que**
le dispositif (3) de test a en outre un troisième contact (14) de liaison au système (2) de frein,
l'interrupteur (13) est constitué en commutateur multipolaire, qui a une première position d'interrupteur et une deuxième position d'interrupteur et est relié au premier contact (11) et au deuxième contact (12), de manière à ce que l'interrupteur (13) soit dans la deuxième position d'interrupteur,
comprenant un pôle, qui relie le premier contact (11) au deuxième contact (12) par le dispositif (L1) d'affichage, et,
comprenant un autre pôle, qui relie le premier contact (11) au troisième contact (14).

2. Dispositif (3) d'essai suivant la revendication 1, dans lequel le dispositif (3) d'essai est constitué de manière à être portatif.

3. Procédé d'essai d'un système (2) électropneumatique de freinage de trains (1) par un dispositif (3) d'essai suivant l'une des revendications précédentes, comprenant les stades :
- liaison manuelle du dispositif de liaison, du côté du dispositif d'essai, de l'interface (10) au dispositif de liaison, du côté du système de freinage ;
- mise manuelle de l'interrupteur (13) dans la deuxième position d'interrupteur ;
- signalisation de la mise de l'interrupteur (13) dans la deuxième position d'interrupteur au système (2) électropneumatique de freinage par le dispositif (3) d'essai, la signalisation de la mise de l'interrupteur (13) dans la deuxième position d'interrupteur s'effectuant par une mise en court-circuit d'un circuit oscillant de frein d'urgence ;
- mise d'une position de freins de train par le système (2) électropneumatique de freinage sur la base de la signalisation de la mise de l'interrupteur (13) dans la deuxième position d'interrupteur ;
- affichage, par le dispositif (L1) d'affichage, de la mise de la position de freinage par le système électropneumatique de freinage ;
- contrôle manuel de la position des freins du train et du signal du dispositif (L1) d'affichage.

4. Procédé d'essai suivant la revendication 3, dans lequel on relie le dispositif (3) d'essai sur une voiture (5) la plus en arrière au dispositif de liaison, du côté du système de freinage, de l'interface (10).

5. Procédé d'essai suivant la revendication 3 ou 4, dans lequel la mise de la position de freinage a lieu manuellement.

6. Procédé d'essai suivant la revendication 3 ou 4, dans lequel la mise de la position de freinage s'effectue automatiquement par le système électropneumatique de freinage.

7. Procédé d'essai suivant l'une des revendications 3 à 6, dans lequel le procédé a le stade :
contrôle d'un état normal de la normalité conforme aux prescriptions de ligne de commande de train du système électropneumatique de freinage pendant un fonctionnement en circulation.

8. Procédé d'essai suivant la revendication 7, dans lequel on effectue le contrôle en permanence dans le fonctionnement en circulation.
